# EUROPEAN PATENT APPLICATION

(11) **EP 3 404 589 A1**
(43) Date of publication of application: **21.11.2018**
(21) Application number: 17171745.7
(22) Date of filing: 18.05.2017
(51) Int. Cl.: G06Q 10/00

(54) **COMPUTER SYSTEM AND METHOD FOR IMPROVED MONITORING OF THE TECHNICAL STATE OF INDUSTRIAL SYSTEMS**

(71) Applicant: ABB Schweiz AG, 5400 Baden (CH)
(72) Inventor: Hollender, Martin, 69221 Dossenheim (DE); Harjunkoski, Iiro, 69469 Weinheim (DE); Li, Nuo, 68161 Mannheim (DE); Chioua, Moncef, 69115 Heidelberg (DE); Graven, Tone-Grete, 1450 Nesoddtangen (NO); Rozou, Maria, 8050 Zürich (CH)
(74) Representative: Bittner, Peter

(57) **Abstract**

Computer system (100), computer-implemented method and computer program product are provided for analyzing the technical state of an industrial system (200). The computer system has an interface module (110) configured to: access a plurality of signals (SS1 to SSm) describing the technical state of the industrial system (200) at respective time points wherein the signals correspond to or are derived from raw sensor data generated by sensors (S1 to Sn) of the industrial system (200); receive an indicator (I1) for a signal of interest (Sol) to be used for diagnosis of the current technical state; and provide one or more associated signals (AS) to a diagnostic system analysis user (10) as a recommendation (R1) for diagnostic parameters. A data analyzer module (120) can retrieve the associated signals (AS) by using one or more of the following criteria: use of the associated signals (AS) in combination with the signal of interest (Sol) in diagnostic activities regarding an abnormal technical state in the past; existence of technical dependencies between the signal of interest (Sol) and the associated signals (AS); and result of a problem resolution activity in the past as a result of diagnostic activities based on the associated signals (AS) in combination with the signal of interest (Sol) regarding an abnormal technical state in the past.

## Description

### Technical Field

The present invention generally relates to state monitoring of industrial systems, and more particularly, relates to methods, computer program products and systems for analyzing the technical state of an industrial system.

### Background

Industrial systems (e.g., production plants, smart buildings, ventilation systems, etc.) are typically monitored by using sensors which sense technical parameters of a particular industrial system reflecting its technical state. For example, process plants typically have tens of thousands of signals to monitor the technical state and hundreds of displays and dashboards for prompting one or more diagnostic system analysis users with the technical state information to take corrective action in the industrial system if the technical parameters indicate a need for such action. However, it requires long experience to build up the knowledge about the relations between the signals and their relevance for the technical state analysis. Engineers typically use signal lists, P&IDs (piping and instrumentation diagrams), displays and dashboards as support for their search for signals which are relevant to the analysis of specific situations (represented by respective technical state parameters). Signal naming is often done systematically according to the structure of the monitored system (e.g., ISO 16952, IEC 81346). For example, ISO 16952 describes how to define naming conventions for technical systems under functional, local and product specific aspects. The application of such standards can lead, for example, to a signal name "F1 HP01BT03-BT01" representing a temperature sensor being part of a separation system HP01 of distillation F1. In such implementations, a simple alphabetically sorted list of the signal names already puts related signals close to each other. On the other hand, the current state of the art for proposing related signals does not go beyond such an alphabetically sorted list and leaves the operators (e.g., diagnostic system analysis users) in doubt about the appropriate combination of signals which needs to be analyzed with regards to a particular technical state of the industrial system (e.g., a pump failure, overheating, etc.).

### Summary

There is therefore a need to provide improved means for the operators which better support the identification of relevant signal combinations characterizing particular technical states of the industrial system. This technical problem is solved by embodiments in the form of a computer system, a computer-implemented method and a computer program product according to the independent claims.

In one embodiment, a computer system is provided for analyzing the technical state of an industrial system. The computer system includes an interface module to access a plurality of signals describing the technical state of the industrial system at respective time points wherein the signals correspond to or are derived from raw sensor data generated by sensors of the industrial system. For example, such sensor signals can be temperature values measured by temp sensors, vibration values measured by vibration sensors, flow values measured by flow meters, and so on. Sometimes the provided signals are not the raw data itself but values derived directly form the raw data by some sort of data-preprocessing. For example, the provided temperature values may correspond to average temperature values during a predefined sampling rate. The person skilled in the monitoring of industrial systems knows all kinds of meaningful data-preprocessing methods to generate technical state parameter data providing meaningful information about the technical state of the industrial system.

The interface module further includes a user interface portion which allows the operator(s) to interact with the computer system for performing diagnostic analysis of the industrial system based on the accessed signals. Via the user interface the computer system receives (from the operator) an indicator for at least one signal of interest to be used for diagnosis of the current technical state. The at least one signal of interest can be understood as one of one or more key signals which are relevant in the context of the diagnosis of a particular state of the industrial system. For example, if a certain throughput of material is below the expected values at a particular location of the plant, potential signal of interests may be a flow meter signal in proximity to the particular location, a pump control signal for a pump facilitating the flow at the particular location, a level meter signal monitoring a tank providing a liquid as input to the material flow at the particular location, and so on. The received at least one signal of interest is typically selected by the operator based on his/her diagnostic experience. In the following, the term "signal of interest" refers to one or more (at least one) of such key signals.

The computer system further has a data analyzer module to retrieve from the plurality of signals one or more further signals associated with the signal of interest. The associated signals in combination with the signal of interest reflect the current technical state of the industrial system and are determined by one or more of the following criteria: use of the associated signals in combination with the signal of interest in diagnostic activities regarding an abnormal technical state in the past, existence of technical dependencies between the signal of interest and the associated signals, and the result of a problem resolution activity in the past as a result of diagnostic activities based on the associated signals in combination with the signal of interest regarding an abnormal technical state in the past.

Dashboards and displays (including report templates) typically relate signals which are relevant to the diagnosis of particular technical states of the industrial system and can be considered as compiled knowledge from experienced engineers with regards to which signals may be analyzed together with a good probability to resolve a problem in the industrial system which is indicated by respective technical state parameters.

For example, the use of the associated signals in the past may be based on one or more of the following criteria:
- the associated signals were retrieved within a predefined time interval around the retrieval time point of the signal of interest in previous diagnostic activities with a probability (or frequency) above a predefined threshold;
- the associated signals were configured in a respective diagnosis user interface by a minimum number of diagnostic system analysis users;
- the associated signals were configured in a respective diagnosis user interface by an expert user; and
- the combination of the associated signals with the signal of interest was marked with one or more indicators for the usefulness of diagnostic activities in the past by one or more diagnostic system analysis users.

For example, the existence of the technical dependencies is based on one or more of the following criteria:
- the associated signals have a connection with the signal of interest in a process and instrumentation diagram;
- in the industrial system the sensors related to the associated signals are in physical proximity to the sensor related to the signal of interest;
- the occurrences of the associated signals show a correlation with the occurrences of the signal of interest for one or more signal sequences in the past, and
- the associated signals have one or more causal relationships with the signal of interest or amongst each other.

Finally, the determined associated signals are provided via the user interface to a diagnostic system analysis user as a recommendation for an enhanced set of diagnostic parameters reflecting the current technical state of the industrial system. Based on the technical information, the user can initiate corrective action with regards to adjustments, recalibration, maintenance/repair works etc. for components of the industrial system which are associated with the determined signals.

In one embodiment, the interface module further receives a time interval indicator. For example, the time interval indicator can be provided as a user input. An optional time filter module of the data analyzer can filter the associated signals in accordance with the time interval indicator. This allows the reduction of the amount of data to be analyzed by the data analyzer by eliminating data sets which are outside the time intervals associated with the received time interval indicator.

In one embodiment, when providing the associated signals to the diagnostic system analysis, at least a subset of the associated signals may be highlighted if the subset relates to an alarm which occurred during the time interval of interest user.

In one embodiment, the data analyzer further includes a ranking module with a ranking scheme which defines different weights for the respective retrieval criteria. The ranking scheme reflects different grades of reliability of respective signals with regards to their relevance to a particular state of the industrial system. For example, a use of certain signals by an expert user may be higher ranked than a use by less experienced users because it is more likely that the expert user (based on experience) has selected the relevant signals in a similar situation. The data analyzer then applies the ranking scheme to the associated signals so that the retrieved associated signals are ranked in accordance with the ranking scheme and the associated signals are presented to a diagnostic system analysis user according to their ranking with the highest ranked associated signal first. This improves the efficiency of system diagnostics in cases of state anomalies of the industrial system because the sets of signals with the highest probability to contribute to problem resolution are recommended with priority compared to other sets with a lower probability. As a consequence, for time critical state anomalies (e.g., a shut down of the industrial system to be expected) quasi-real-time diagnostics allows to quickly identify the root cause of the anomalies and initiate counter measures to avoid system downtime or even system damage of the industrial system.

In one embodiment, the data analyzer can retrieve a particular device type associated with the device of which the technical state is monitored by the signal of interest, and then can determine one or more behavior properties of the signal of interest which were used for previous diagnostic activities regarding the technical state of devices having the particular device type. Thereby, the associated signals are determined based on the one or more determined behavior properties.

In one embodiment, the signal of interest relates to the technical state of a particular device of the industrial system and the data analyzer retrieves associated signals which relate to the same particular device. In an alternative embodiment, the data analyzer retrieves associated signals which relate to the technical state of a further device of the industrial system which has the same device type as the particular device.

In one embodiment, a computer program product includes instructions that when loaded into a memory of the computer system and executed by at least one processor of the computer system cause the computer system to perform the functions of the computer system as disclosed and to execute the steps of a corresponding computer-implemented method.

Further aspects of the invention will be realized and attained by means of the elements and combinations particularly depicted in the appended claims. It is to be understood that both, the foregoing general description and the following detailed description are exemplary and explanatory only and are not restrictive of the invention as described.

### Brief Description of the Drawings

FIG. 1 shows a simplified block diagram of a computer system monitoring the technical status of an industrial system according to one embodiment;
FIG. 2 is a simplified flowchart of a computer-implemented method according to an embodiment;
FIG. 3 illustrates a first example scenario with various associated signals according to an embodiment;
FIG. 4 illustrates a second example scenario with various associated signals according to an embodiment; and
FIG. 5 is a diagram that shows an example of a generic computer device and a generic mobile computer device, which may be used with the techniques described here.

### Detailed Description

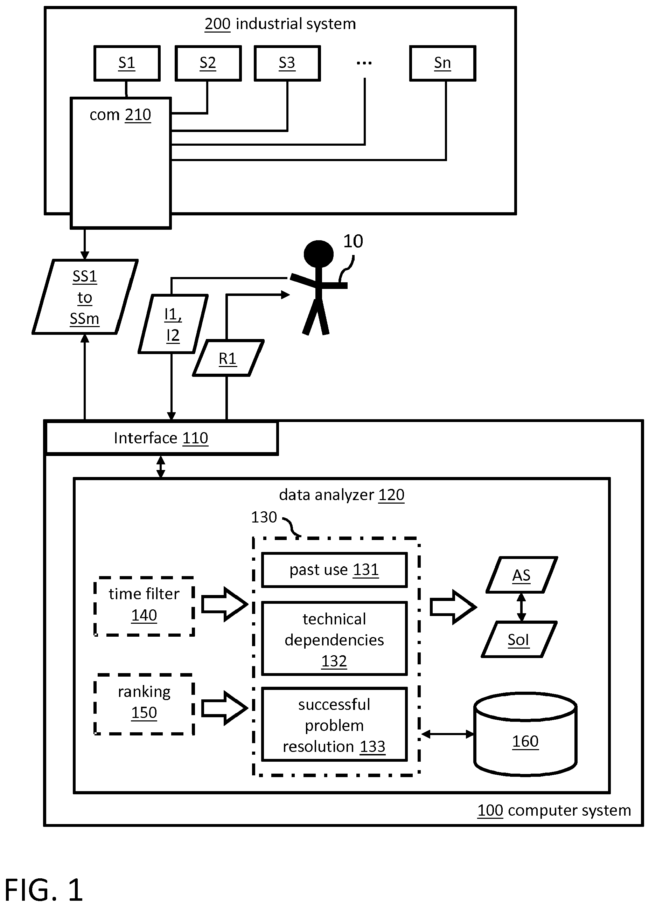

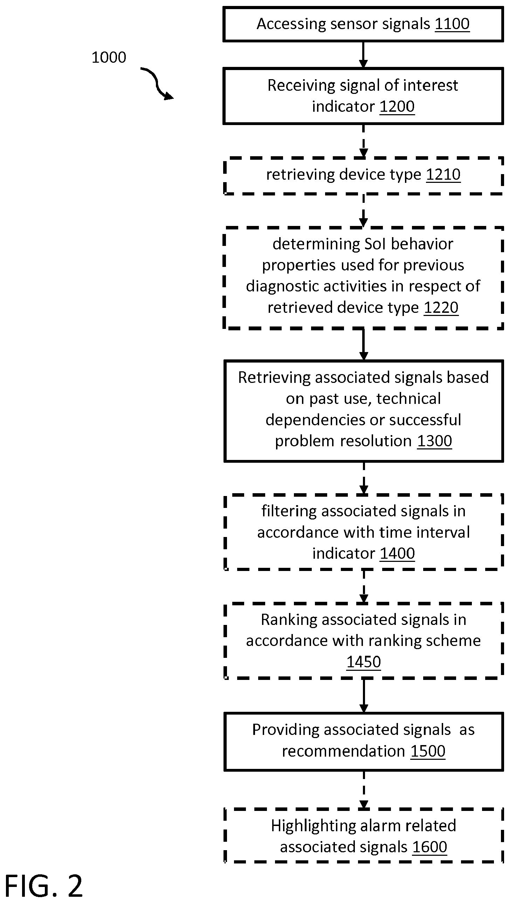

FIG. 1 shows a simplified block diagram of a computer system 100 for analyzing the technical state of an industrial system 200 according to an embodiment. The computer system 100 and the industrial process system 200 are communicatively coupled via standard interface technology enabling the exchange of data between the two systems. For example, the two systems may be connected via a local area network such as an intranet of the operator of the system (e.g., LAN, WLAN) or a wide area network (e.g., the Internet). FIG. 2 is a simplified flowchart of a computer-implemented method 1000 for analyzing the technical state of the industrial system 200 according to an embodiment. In the following description, functions performed by the computer system 100 are described in the context of the flow chart of FIG. 2. Therefore, the following description refers to reference numbers of FIG. 1 and FIG. 2.

The industrial system 200 can be any technical system used for industrial purposes. For example, it can be a production plant for process or discrete manufacturing, a automation or control system for a smart building, a ventilation system for an underground mine, a traffic control system, a power plant (coal, nuclear, solar, wind, etc.), and so on. Typically, the technical state of such industrial systems 200 is monitored by a plurality of sensors S1 to Sn wherein each sensor provides technical state data in relation to or more components of the industrial system. The sensor data describes the technical state of the entire industrial system 200 at the level of granularity as provided by the available sensors S1 to Sn. In the example, a communication gateway 210 is used to collect the sensor data and to provide technical state data SS1 to SSm to external systems, such as the computer system 100. The technical state data SS1 to SSm are also referred to as signals SS1 to SSm herein. Thereby, the provided signals can correspond to raw sensor data generated by the sensors S1 to Sn or are they may be derived from the raw sensor data by applying some sort of data preprocessing (e.g., averaging or otherwise aggregating the raw data, for example, to save bandwidth in the data transmission). In general, the signals are time stamped to describe the technical state of the industrial system 200 at respective time points.

The computer system 100 for analyzing the technical state of the industrial system 200 has an interface module 110 to access 1100 the signals SS1 to SSm. Further, the interface 110 includes a human-machine (user) interface which allows a user 10 to interact with the computer system 100. In other words, the user can input data via the interface 110 and the system 100 can output data to the user 10. Standard Input/output (I/O) means can be used for this purpose. System 100 receives 1200 an indicator I1 for a signal of interest Sol to be used for diagnosis of the current technical state of the industrial system 200. Typically, the Sol is initially provided by the diagnostic system analysis user 100 based on his/her past diagnostics experience as input to the data analyzer module 120 of the computer system 100. For example, in case of an unexpectedly low material throughput at a particular plant location measured by a first flow meter, the user 10 may select an indicator of a second flow meter signal derived from a second flow meter sensor which is mounted upstream in the proximity of the particular plant location. Alternatively, the user 10 may select a sensor signal indicating the operation state of a pump which is located upstream. In some implementations, the data analyzer may automatically detect unusual sensor values by applying respective data analytics algorithms to the accessed sensor data. For example, machine learning algorithms can be trained for normal operating conditions of the industrial system and can detect abnormal situations when applying the learned patterns to the actual sensor data reflecting the technical state of the industrial system. In such implementations, the computer system can propose one or more potential signals of interest to the user 10.

The received indicator I1 is used by the data analyzer module 120 to retrieve 1300 associated signals AS from the plurality of signals SS1 to SSm. The associated signals AS can be determined by a plurality 130 of submodules by using different criteria. The various criteria are discussed in the following in a generic way and will later on be explained in the context of specific example scenarios.

One possible criterion is the use of the associated signals AS in combination with the signal of interest Sol in diagnostic activities regarding an abnormal technical state in the past. A corresponding past use submodule 131 of the data analyzer 120 can evaluate historic signal data in relation to the Sol.

For example, the past use submodule 131 can determine signals which were retrieved within a predefined time interval around the retrieval time point of the signal of interest in previous diagnostic activities with a probability above a predefined threshold. In other words, submodule 131 checks if the received Sol was already used in earlier diagnostic activities (e.g., by checking a database 160 which takes record of all diagnostic activities). If so, signals which were retrieved during a predefined retrieval interval, before or after the past retrievals of signals corresponding to the current Sol are good candidates for associated signals. In cases where such candidate signals were retrieved always in combination with the Sol like signals during, or at least with a probability above the predefined threshold, such candidates qualify as associated signals. It is to be noted that it is not necessary that the Sol like signals of the historic signal sequences were used as the Sol in those past diagnostic activities. It is sufficient that they were used in combination with the associated signals - also in such cases where the combination of signals used in the past diagnostic activity was collected based on another Sol.

For example, the past use submodule 131 can determine associated signals which were configured in a respective diagnosis user interface by a minimum number (i.e. by at least a predefined number) of diagnostic system analysis users. In this example, the database storing all historic diagnostic activity data records is queried to identify all past user interface configurations which include the Sol together with the same set of signals. If the identified configurations were used at least by a (predefined) minimum number of users, the signals included in such configuration which are different from the Sol are qualified as associated signals.

Similar to the previous example is a further example where the associated signals were configured in combination with a Sol like signal in a respective diagnosis user interface by an expert user. In this case, the historic diagnostic activity database 160 stores a level of experience of the user with each diagnostic user interface configuration. Instead of looking for a minimum number of users to establish sufficient trust in the configuration, the past use submodule 131 checks the level of experience of the respective diagnostic system analysis users. It at least one expert user (user with minimum level of experience, i.e., a user whose level of experience is flagged as expert level by corresponding data in the computer) has defined such a configuration, the corresponding signals which are different from the Sol qualify as associated signals.

In a further example, the combination of the associated signals with the signal of interest was marked with one or more indicators for the usefulness of diagnostic activities in the past by one or more diagnostic system analysis users. In this example, the historic diagnostic activity database 160 can store markings (e.g., flags, numbers, etc.) for each diagnostic user interface configuration indicating the usefulness as perceived by the user at the time it was used. Based on the marking the past use submodule 131 can filter such out all configurations which were not rated useful and qualify the signals of the remaining configurations as associated signals.

Another possible criterion for the determination of associated signals is the existence of technical dependencies between the signal of interest Sol and the associated signals AS. A technical dependencies submodule 132 of the data analyzer 120 can evaluate signal data in relation to the Sol and can identify such signals which are related to the Sol based on such technical dependencies.

For example, technical dependencies between the Sol and associated signals may be determined by the submodule 132 when the associated signals have a connection with the signal of interest Sol in a piping and instrumentation diagram (P&ID). P&IDs are a standard documentation for many industrial process systems describing their topologies. If, for example, a pump is connected with a flow meter in the P&ID, then there is a clear technical dependency between the signal reflecting the operating mode of the pump (on/off) and the respective flow meter value. When the pump is off the flow meter value is supposed to be zero.

For example, technical dependencies between the Sol and associated signals may be determined by the submodule 132 when the sensors related to the associated signals AS are in physical (spatial) proximity to the sensor related to the signal of interest Sol. Physical proximity can be derived from a map of the industrial system where the various sensor locations are indicated. For example, sensors which are grouped in a certain part of the plant may follow a naming convention which implies that they are located in this part. In this example the names of the signals may serve as an indicator for physical proximity. For example, the following signal names may exist: A21FICA_0185-MV, A21_FICA_0185_-POUT, A21_FICA_0185_-WSP, A21FICA_0187_-MV, A21FICA_0187_-POUT. A query "A21FICA*" may retrieve all flow control loops (0185, 0187) in plant section A21. In the example, the ending "WSP" represents a setpoint and "MV" represents the measured value of the flow of the same control loop.

For example, submodule 132 may identify occurrences of a subset of signals showing a correlation with the occurrences of the signal of interest for one or more signal sequences in the past. In this case, the subset of signals can qualify as associated signals because the correlation may be an indicator for a technical dependency of the subset of signals with the Sol. For correlating the signals standard correlation methods may be used. Various correlation coefficients may be used to measure the degree of correlation. The most common of these is the Pearson correlation coefficient, which is sensitive only to a linear relationship between two variables which may be present even when one variable is a nonlinear function of the other. Other correlation coefficients are available which are more robust than the Pearson correlation - that is, more sensitive to nonlinear relationships. Correlation of signals may be based on the occurrences of the signals. Correlation of signals may also be based on correlated behavior of signals. For example, if a first signal shows an (unusual) oscillating behavior, a correlation with a second signal may be detected when the second signal also shows such oscillating behavior.

For example, submodule 132 may identify associated signals as signals having a causal relationship with the signal of interest Sol or amongst each other. Whereas the previous correlation methods do not imply causal relationships when detecting a correlation, this embodiment actually identifies the associated signals based on a known technical dependency, such as for example, a physical connection between the sources of the respective signals. It is also possible to automatically determine causal relationships between signals by use of sophisticated algorithms which can derive causal relationships from certain signal correlations. For example, submodule 132 may identify a first associated signal which has a causal relationship with the Sol. A second associated signal may then be identified which has a causal relationship with the first associated signal, and so on. This way, the plurality of associated signals may reflect a whole causal chain.

Another possible criterion for the determination of associated signals is a known result of a problem resolution activity in the past as a result of diagnostic activities based on the associated signals in combination with the signal of interest regarding an abnormal technical state in the past. For example, the diagnostic activity database 160 may track the success or failure of diagnostic activities. A successful problem solution result can be determined and recorded when the industrial system resumes operation after a particular diagnosis configuration with a particular set of associated signals and Sol was used earlier. A failure result can be determined and recorded when a downtime state of the industrial system remains after a corresponding diagnosis configuration was used earlier.

Such criteria may be used alone or in combination to determine associated signals for the received Sol having a high probability of being relevant to the current technical state of the industrial system. A skilled person will recognize that it is advantageous to apply the one or more criteria in situations where the current technical state of the industrial system indicates a mal-functioning (current or future) of the system so that the set of Sol and associated signals provides relevant technical information to the user to resolve the current problem of the industrial system.

Finally the one or more further signals AS associated with the signal of interest Sol are provided 1500 (via the user interface) to the diagnostic system analysis user 10 as a recommendation R1 for an enhanced set of diagnostic parameters reflecting the current technical state of the industrial system 200. In other words, the recommendation R1 includes a set of associated signals as diagnostic parameters which likely allows the user to quickly and efficiently identify the root cause of an abnormal technical status of the industrial system and take corrective action. Based on this recommendation the user can apply one or more of the determined signals as diagnostic user interface configurations for performing a detailed analysis of the situation to identify the root cause of a current or future malfunctioning of the industrial system and trigger respective counter measures.

In one embodiment, the data analyzer may further have a time filter module 140. In this embodiment, the interface module 110 can further receive a time interval indicator I2. The time interval indicator I2 specifies one or more time intervals of interest. The time filter 140 then filters 1400 the associated signals in accordance with the time interval indicator 12. That is, the modules 130 will then perform their respective analyses on data records which are/were recorded during the specified time interval(s) of interest. The time interval indicator I2 may be received from the operator 10 or from another computer system.

In this embodiment, the data analyzer 120 may identify a subset of the associated signals (or the entire set of associated signals) related to an alarm which occurred during the time interval of interest. Alarms are typically raised when a characteristic set of signals associated with critical technical state of the industrial system is observed within a respective time interval of interest. In case an alarm is detected, the recommendation R1 provided to the user can highlight 1600 the subset of signals to the user 10 to immediately indicate a potential combination of associated signals and Sol which is associated with an already known alarm. The user can then take corrective action in response to this alarm.

In one embodiment, the data analyzer 120 of the computer system 100 may store a ranking scheme 150 which defines different weights for the respective retrieval criteria. The weights are predefined to differentiate between less promising signals (lower weights) from promising signals (higher weights) in terms of their potential to contribute to the resolution of a technical problem in the industrial system. The data analyzer 120 applies the ranking scheme to the associated signals AS so that the retrieved associated signals are ranked 1450 in accordance with the ranking scheme 150. In the recommendation 1500, the associated signals can then be presented to the diagnostic system analysis user 10 according to their ranking, for example, with the highest ranked associated signal first. The ranking information may also be reflected by other visualization techniques. For example, a color scheme can be used where ranking positions are mapped to corresponding colors. For example, the signals ranked above a predefined ranking position may be highlighted (e.g., by bold lines or by appropriate animations such as blinking). The use of a ranking scheme allows to support the diagnostic system analysis user 10 in differentiating less promising associated signals from promising signals with regards to their probability for succeeding with a root cause analysis based on the selected associated signals.

For example, a ranking scheme may assign the highest weight on the retrieval criterion of the result of a problem resolution activity in the past as a result of diagnostic activities based on the associated signals AS in combination with the signal of interest Sol regarding an abnormal technical state in the past. As a consequence, combinations of associated signals which were used in diagnostic activities leading to a resolution of the problem may be ranked highest and combinations of associated signals which did not lead to resolution may be ranked lowest.

The various uses of the associated signals in the past may have lower weight than the problem resolution related weight(s). Thereby, different weights may be used for the different types of past use criteria 131. For example, a higher weight may be assigned to combinations of the associated signals with the signal of interest being marked with positive indicators for the usefulness of diagnostic activities in the past by one or more diagnostic system analysis user than to the associated signals which were configured in a respective diagnosis user interface in combination with the signal of interest by an expert user. The expert user signals again may receive a higher weight than the associated signals which were retrieved within a predefined time interval around the retrieval time point of the signal of interest in previous diagnostic activities with a probability above a predefined threshold. Even a lower weight may be assigned to associated signals which were configured in a respective diagnosis user interface in combination with the signal of interest by a minimum number of diagnostic system analysis users - especially if no expert users were amongst such users. Nevertheless, the minimum number of users signals may still receive a higher weight than combinations of associated signals with the signal of interest being marked with negative indicators for the usefulness of diagnostic activities in the past by one or more diagnostic system analysis user.

The weights related to the existence of technical dependencies 132 between the signal of interest Sol and the associated signals AS may be higher or lower than the previously discussed weight examples. For example, associated signals AS having a causal relationship with the signal of interest Sol may receive the highest weight of all criteria because the configuration of the industrial system implies respective dependencies between such signals which may have a positive impact to quickly identify a resolution to a problem in the industrial system by diagnostic activities based on such signals. The criterion that occurrences of the associated signals AS show a correlation with the occurrences of the signal of interest for one or more signal sequences in the past may receive a much lower weight because such correlations may also occur accidentally. Also the criteria regarding a P&ID connection between signals or the physical proximity of respective sensor may have relatively low weights. For example, they may be used as additional information complementing the past use criteria. It is to be noted that the ranking scheme may be different for different industrial systems and for users of different technical expertise. In a first case users 10 may have a different level of expertise than in a second case. This may lead to a ranking scheme where past use criteria are ranked higher than technical dependency criteria in the first case and vice versa in the second case.

In one embodiment, the data analyzer 120 may receive the indicator I1 for the Sol in relation to a flow value (Sol) captured by flow meter F1 (i.e., the flow value indicating the technical state of F1). The data analyzer may identify such associated signals which relate to the same flow meter F1. However, this embodiment may not make use of further useful information available in the historic diagnostic activity database 160 regarding signals of similar devices.

For this purpose, in another embodiment, the data analyzer can retrieve 1210 a particular device type associated with the device of which the technical state is monitored by the signal of interest Sol. For example, if the Sol indicates the flow value captured by the flow meter F1 then the data analyzer can retrieve the F1 device type "Differential Pressure Flow Meter" from a corresponding device database. Other flow meters may be used in the industrial system which may be of other device types (e.g., "Positive Displacement Flow Meter", "Velocity Flow Meter", "Mass Flow Meter", "Open Channel Flow Meter"). In this example, although the signal of interest relates to the technical state of the particular flow meter F1 of the industrial system, the associated signals may relate to the technical state of one or more further flow meter devices of the industrial system, wherein the further devices have the same device type "Differential Pressure Flow Meter" as the particular flow meter F1.

In one embodiment, upon receiving 1200 the indicator I1 for the signal of interest, the computer system can retrieve 1210 a particular device type associated with the device of which the technical state is monitored by the signal of interest Sol. The data analyzer can then determine 1220 one or more behavior properties of the signal of interest which were used for previous diagnostic activities regarding the technical state of devices having the particular device type. For example, a level meter value for a particular tank may be oscillating. The oscillating behavior of level meters may have been used in the past for diagnostic activities for other level meters associated with tanks. Based on the oscillating behavior of level meter devices associated with tanks other signals also showing an oscillating behavior can be determined as associated signals.

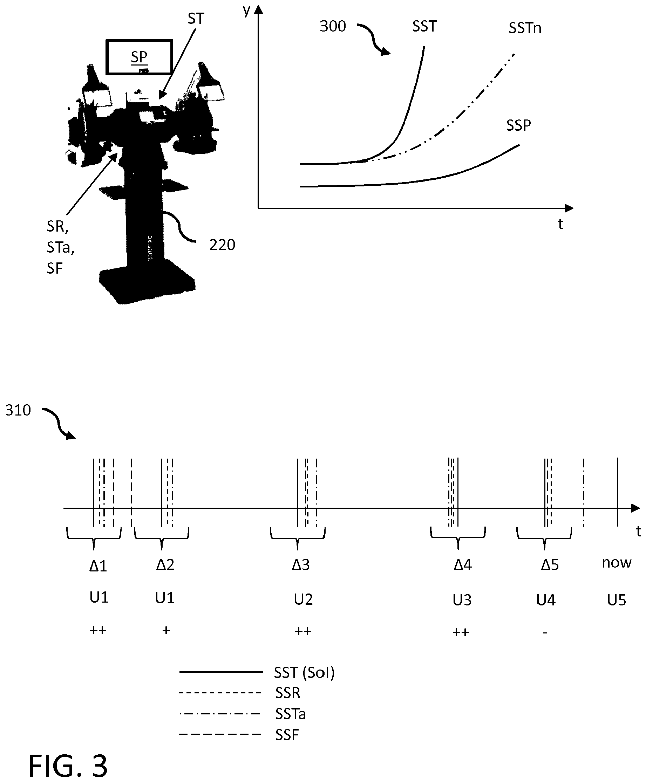

FIG. 3 illustrates particular signals which occurred over time t in a first example scenario. The first example scenario relates to a grinder 220 which is part of an industrial system. The grinder 220 has a temperature sensor ST mounted in such a way that it can monitor the temperature of the windings of the grinder. The signal SST of the temperature sensor is the signal of interest for the further diagnostic activities. Diagram 300 illustrates the normal behavior SSTn of the winding temperature of the grinder 220 which normally increases as a consequence of increased power consumption SSP (e.g., measured by a power meter SP for the grinder). That is, there is a causal relationship between SSTn and SSP which reflects normal system behavior in diagram 300. However, the current trend of the signal SST provided by the sensor ST, shows an unexpected raise in the winding temperature SST. A reason for this unexpected trend may be that the cooling system (heat exchanger) of the grinder 220 is not working correctly. The cooling system (inside the housing of grinder 220) in the example is monitored by a temperature sensor STa measuring temperature signal SSTa reflecting the air temperature in the heat exchanger, a flow meter sensor SF measuring the signal SSF reflecting the flow of cooling water, and one or more sensors SR measuring the revolutions/second SSR of the cooling fan(s).

The lower part of FIG.3 shows a simplified diagram 310 which illustrates at which times t the respective signal values (signal trends of the signals SST, SSR, SSTa, SSF) were retrieved for diagnostic activities. Units of the y-axis correspond to the units of the respective signal values. It is assumed that SST shows an extraordinary raise in temperature (as shown in diagram 300) and is used by a diagnostic system analysis user as the signal of interest Sol. To identify associated signals for complementing a diagnostic view on the technical state of the grinder 220, the data analyzer of the computer system can, for example, perform a past use analysis and retrieve within a predefined time interval Δi around the retrieval time point of the signal of interest Sol in previous diagnostic activities with a probability above a predefined threshold. In the example, during the time interval Δ1, the sequence SSR, SSTa and SSF was retrieved right after the retrieval of the Sol. During Δ2, only SSR and SSTa were retrieved after Sol. SSF was actually retrieved before Sol and outside the interval Δ2. During time interval Δ3, again SSR, SSTa and SSF were retrieved after Sol. During Δ4, SSR, SSTa and SSF were retrieved before Sol. During Δ5, SSR and SSF were retrieved after Sol whereas SSTa was also retrieved after Sol but outside Δ5. That is, for the signal SSR the probability that it was used in combination with the Sol for diagnostic activity is 100 %. For the signals SSF and SSTa the probability is 80%. Assuming a probability threshold of 70% for a signal to qualify as an associated signal, all signals SSR, SSTa and SSF would be provided to the user as signals associated with the Sol SST and therefore being good candidates for analyzing the root cause of too high temperature values for SST. In this embodiment, the historic diagnostic activity database provides information which signal trends were sequentially analyzed in the context of the Sol.

In another embodiment, users may have saved configurations of diagnostic views with combinations of signals whose trends were analyzed simultaneously. Assuming that each of the collection of signals retrieved during the time intervals Δ1 to Δ5 were saved as a configuration view for the respective user (U1 to U4) either by the user or by the system automatically recording all diagnostic activities, the data analyzer can provide associated signals to the current user U5 based on such historic configuration views if the respective configuration was used by a minimum number of users. For example, if the required minimum number of users is defined as three, then the configurations associated with Δ1 (U1), Δ3 (U2), and Δ4 (U3) fulfill the criterion and the respective associated signals SSR, SSTa and SSF are provided to the current user U5 as associated signals for Sol SST.

In another embodiment, the users may also store markings regarding the usefulness of a configuration. In the example, the marking "-" stands for "not so useful", "+" stands for useful, and "++" stands for "very useful". The markings alone may be used by the data analyzer to generate a corresponding recommendation of associated signals to the current user 5. In the example, the configurations including SSR, SSTa and SSF are all ranked "++" and can be provided to the current user U5. The markings may also be used to filter configurations which were preselected via the previously explained criterion of a minimum number of users. In case different configurations were used by the minimum number of users, the data analyzer may discard all configurations which are flagged "-" as not so useful.

In another embodiment, the data analyzer may prioritize past use configurations saved for expert users. Let user U2 be an expert user whereas the other users have less experience. In this case the data analyzer would rely on the configuration associated with Δ3 which was recorded while the expert user U2 performed the analysis.

Technical dependencies may also be used in the first example scenario of FIG. 3 to some extent. For example, there is a trend towards generating so called digital twins for industrial systems. Digital twins refer to computerized companions of physical assets that can be used for various purposes. Digital twins typically use data from sensors installed on physical objects to represent their near real-time status, working condition or position. If such information is available for the industrial system, the data analyzer can retrieve the knowledge about the positions of the sensors SST, SSR, SSTa and SSF from such a digital twin and derive from this information that all such sensors are mounted on the grinder 220 and are therefore in physical proximity.

In one embodiment, the data analyzer may analyze correlations between occurrences of the signal of interest SST for one or more signal sequences in the past and the occurrences of other signals. For example, in the past there may have been several incidents where the Sol SST showed an unexpected raise in temperature and other signals which occurred around the time of the unexpected temperature raise also show an unexpected change in their values. For example, in some cases, when an SST winding temperature raise was observed for the grinder 220, the temperature signal SSTa reflecting the air temperature in the heat exchanger has increased and the signal SSF reflecting the flow of cooling water has decreased. In other cases, the revolutions/second SSR of the cooling fan(s) have gone down. It is not necessary that the past occurrences of the Sol were observed for the grinder 220 itself. It can be sufficient when the Sol was observed for other grinders of the same device type as grinder 220. There is a high probability that devices of the same device type suffer from similar technical deficiencies. The applied correlation method may now identify the signals SSTa, SSF and SSR as signals associated with the Sol SST.

In a further embodiment, technical decencies for the above scenario can be inherent to the construction of the industrial system and its grinder 220. In the grinder example, a causal relationship exists between the flow signal SSF and the temperature SST. When the cooling flow is reduced, as a physical consequence, the winding temperature SST increases. Such causal relationship can be either predefined (e.g. as knowledge stored in a digital twin of the industrial system) or it may be learned by the computer system (e.g., via machine learning algorithms) over time from observing the technical parameters (sensor values) of the industrial system. That is, the data analyzer identifies SSF as an associated signal because of its technical dependency on the Sol SST.

In the first example scenario, the various criteria for identifying associated signals can be applied in parallel or in sequence by the data analyzer. To provide a reliable set of associated signals to the user the data analyzer can prioritize the results of the various identification options by using the ranking scheme and applying weights to the various results. For example, technical dependencies based on causal relationships of signals may receive a relatively high weight (e.g., 30%) whereas technical dependencies solely determined via correlation methods may receive a lower weight (e.g., 5%). Results based on the past use of configurations by an expert user may also receive a relatively high weight (e.g., 20%) whereas results based on the minimum-number-of-user criterion may receive a lower weights (e.g., 10%). The weight of the minimum number of users criterion may be increased when positive markings (e.g., 20%) were recorded for respective configurations. The weight of configurations which finally led to a resolution of the observed abnormal situation in the technical system may receive highest priority (e.g., a weight of 50%). Such configurations can be flagged accordingly in the historic database if the configuration finally led to a restart of the industrial system after it was stopped due to the abnormal situation. The ranking scheme can be predefined in such a way that it takes into account the nature of the industrial system and the skills of the diagnostic system analysis users.

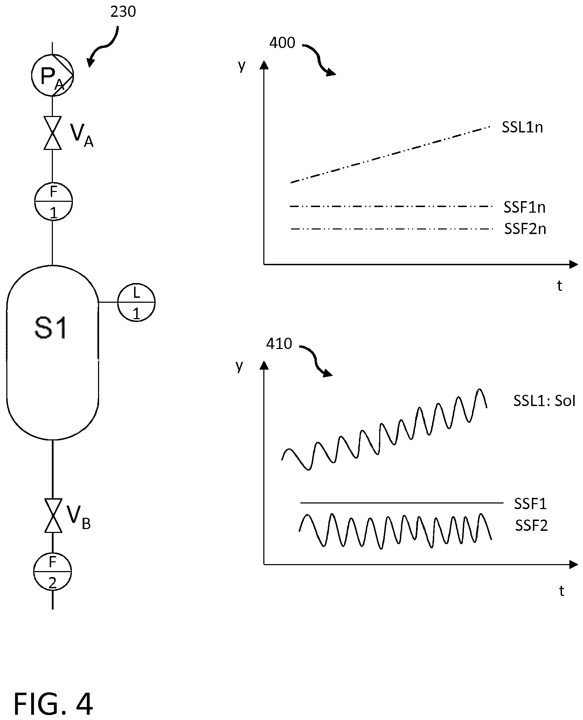

FIG. 4A illustrates a second example scenario, where the industrial system is a process system (represented by P&ID 230) which includes a pump PA, valves VA, VB, flow meters F1, F2, tank S1 and level meter L1. The pump PA can pump liquids into the tank S1. The connection between the pump and the tank includes input valve VA and flow meter F1 to measure the flow between the pump and the tank. For example, flow may be measured by measuring the velocity of fluid over a known area. Level meter L1 is attached to the tank and can measure the filling level of the tank S1. The outflow of the tank can be regulated via valve VB and can be measured via flow meter 2. The simplified diagram 400 shows the normal system behavior in situation where the tank S1 is refilled while providing a constant outflow SSF2n. The constant outflow SSF2n (measured by F2) is slightly lower than the constant inflow SSF1 n (measured by F2). This leads to a linear increase of the filling level reflected by SSL1n (measured by L1). Again, the units of the y-axis correspond to the units of the corresponding signals.

The simplified diagram 410 illustrates an abnormal situation of the process system 230. The signal SSL1 of the level meter L1 shows an oscillating behavior. This indicates a technical problem in the process system. SSL1 is used as the signal of interest Sol for further diagnostic activity. Based on this behavior, the data analyzer can use correlation analysis to identify any further signal showing an oscillating behavior because such oscillation signals can indicate a reason for the abnormal refill behavior of the tank reflected by SSL1. The correlation analysis reveals that the outflow measured by SSF2 also shows an oscillating behavior whereas the inflow measured by SSF1 is constant as expected. The reason can be wear-based malfunctioning of valve VB. Worn-out valves sometimes show jerky switching behavior which can lead to the observed oscillating flow behavior. In this example, the data analyzer can identify SSF2 as associated signal for SSL1 solely based on the technical dependency which is identified through the correlation analysis with regards to the signal behavior. When the outflow is decreasing the refill level is increasing and vice versa. That is, in this example, the correlation algorithm detects a causal relationship between SSF2 and the Sol based on correlation analysis. Once the malfunctioning (e.g., sticky) valve VB is identified the diagnostic system analysis user can initiate its replacement.

Besides the signal behavior related correlation analysis to determine technical dependencies, in the second example scenario, technical dependencies can also be derived from the connection of the signal of interest in the O&ID 230 with other signals. As F1, F2 and L1 have physical connections the respective signals SSF1 and SSF2 are identified as associated signals for Sol SSL1 when using this criterion.

Of course, the past use criteria or the other technical dependencies criteria as explained in the first example scenario of FIG. 3 can be applied also in the context of the example scenario in FIG. 4. Also the successful problem resolution criterion may be applied. Again, a particular ranking scheme can be defined for the process system to put respective weights on the associated signals identified on the basis of the different criteria.

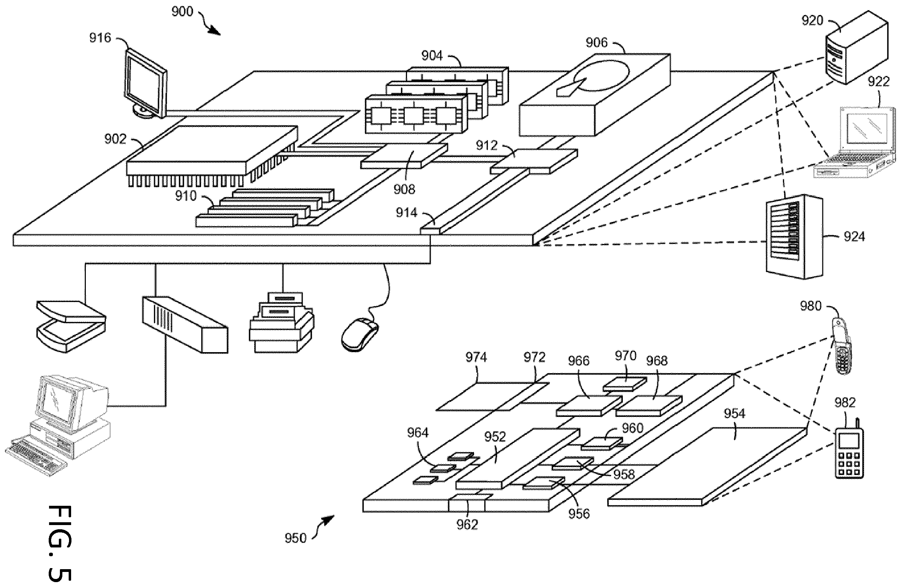

FIG. 5 is a diagram that shows an example of a generic computer device 900 and a generic mobile computer device 950, which may be used with the techniques described here. Computing device 900 is intended to represent various forms of digital computers, such as laptops, desktops, workstations, personal digital assistants, servers, blade servers, mainframes, and other appropriate computers. Generic computer device may 900 correspond to a computer system 100 as illustrated in FIG. 1. Computing device 950 is intended to represent various forms of mobile devices, such as personal digital assistants, cellular telephones, smart phones, and other similar computing devices. For example, computing device 950 may be used by a diagnostic system analysis user for communication with the computer system 900. The components shown here, their connections and relationships, and their functions, are meant to be exemplary only, and are not meant to limit implementations of the inventions described and/or claimed in this document.

Computing device 900 includes a processor 902, memory 904, a storage device 906, a high-speed interface 908 connecting to memory 904 and high-speed expansion ports 910, and a low speed interface 912 connecting to low speed bus 914 and storage device 906. Each of the components 902, 904, 906, 908, 910, and 912, are interconnected using various busses, and may be mounted on a common motherboard or in other manners as appropriate. The processor 902 can process instructions for execution within the computing device 900, including instructions stored in the memory 904 or on the storage device 906 to display graphical information for a GUI on an external input/output device, such as display 916 coupled to high speed interface 908. In other implementations, multiple processing units and/or multiple buses may be used, as appropriate, along with multiple memories and types of memory. Also, multiple computing devices 900 may be connected, with each device providing portions of the necessary operations (e.g., as a server bank, a group of blade servers, or a processing device).

The memory 904 stores information within the computing device 900. In one implementation, the memory 904 is a volatile memory unit or units. In another implementation, the memory 904 is a non-volatile memory unit or units. The memory 904 may also be another form of computer-readable medium, such as a magnetic or optical disk.

The storage device 906 is capable of providing mass storage for the computing device 900. In one implementation, the storage device 906 may be or contain a computer-readable medium, such as a floppy disk device, a hard disk device, an optical disk device, or a tape device, a flash memory or other similar solid state memory device, or an array of devices, including devices in a storage area network or other configurations. A computer program product can be tangibly embodied in an information carrier. The computer program product may also contain instructions that, when executed, perform one or more methods, such as those described above. The information carrier is a computer- or machine-readable medium, such as the memory 904, the storage device 906, or memory on processor 902.

The high speed controller 908 manages bandwidth-intensive operations for the computing device 900, while the low speed controller 912 manages lower bandwidth-intensive operations. Such allocation of functions is exemplary only. In one implementation, the high-speed controller 908 is coupled to memory 904, display 916 (e.g., through a graphics processor or accelerator), and to high-speed expansion ports 910, which may accept various expansion cards (not shown). In the implementation, low-speed controller 912 is coupled to storage device 906 and low-speed expansion port 914. The low-speed expansion port, which may include various communication ports (e.g., USB, Bluetooth, Ethernet, wireless Ethernet) may be coupled to one or more input/output devices, such as a keyboard, a pointing device, a scanner, or a networking device such as a switch or router, e.g., through a network adapter.

The computing device 900 may be implemented in a number of different forms, as shown in the figure. For example, it may be implemented as a standard server 920, or multiple times in a group of such servers. It may also be implemented as part of a rack server system 924. In addition, it may be implemented in a personal computer such as a laptop computer 922. Alternatively, components from computing device 900 may be combined with other components in a mobile device (not shown), such as device 950. Each of such devices may contain one or more of computing device 900, 950, and an entire system may be made up of multiple computing devices 900, 950 communicating with each other.

Computing device 950 includes a processor 952, memory 964, an input/output device such as a display 954, a communication interface 966, and a transceiver 968, among other components. The device 950 may also be provided with a storage device, such as a microdrive or other device, to provide additional storage. Each of the components 950, 952, 964, 954, 966, and 968, are interconnected using various buses, and several of the components may be mounted on a common motherboard or in other manners as appropriate.

The processor 952 can execute instructions within the computing device 950, including instructions stored in the memory 964. The processor may be implemented as a chipset of chips that include separate and multiple analog and digital processing units. The processor may provide, for example, for coordination of the other components of the device 950, such as control of user interfaces, applications run by device 950, and wireless communication by device 950.

Processor 952 may communicate with a user through control interface 958 and display interface 956 coupled to a display 954. The display 954 may be, for example, a TFT LCD (Thin-Film-Transistor Liquid Crystal Display) or an OLED (Organic Light Emitting Diode) display, or other appropriate display technology. The display interface 956 may comprise appropriate circuitry for driving the display 954 to present graphical and other information to a user. The control interface 958 may receive commands from a user and convert them for submission to the processor 952. In addition, an external interface 962 may be provided in communication with processor 952, so as to enable near area communication of device 950 with other devices. External interface 962 may provide, for example, for wired communication in some implementations, or for wireless communication in other implementations, and multiple interfaces may also be used.

The memory 964 stores information within the computing device 950. The memory 964 can be implemented as one or more of a computer-readable medium or media, a volatile memory unit or units, or a non-volatile memory unit or units. Expansion memory 984 may also be provided and connected to device 950 through expansion interface 982, which may include, for example, a SIMM (Single In Line Memory Module) card interface. Such expansion memory 984 may provide extra storage space for device 950, or may also store applications or other information for device 950. Specifically, expansion memory 984 may include instructions to carry out or supplement the processes described above, and may include secure information also. Thus, for example, expansion memory 984 may act as a security module for device 950, and may be programmed with instructions that permit secure use of device 950. In addition, secure applications may be provided via the SIMM cards, along with additional information, such as placing the identifying information on the SIMM card in a non-hackable manner.

The memory may include, for example, flash memory and/or NVRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 964, expansion memory 984, or memory on processor 952, that may be received, for example, over transceiver 968 or external interface 962.

Device 950 may communicate wirelessly through communication interface 966, which may include digital signal processing circuitry where necessary. Communication interface 966 may provide for communications under various modes or protocols, such as GSM voice calls, SMS, EMS, or MMS messaging, CDMA, TDMA, PDC, WCDMA, CDMA2000, or GPRS, EDGE, UMTS, LTE, among others. Such communication may occur, for example, through radio-frequency transceiver 968. In addition, short-range communication may occur, such as using a Bluetooth, WiFi, or other such transceiver (not shown). In addition, GPS (Global Positioning System) receiver module 980 may provide additional navigation- and location-related wireless data to device 950, which may be used as appropriate by applications running on device 950.

Device 950 may also communicate audibly using audio codec 960, which may receive spoken information from a user and convert it to usable digital information. Audio codec 960 may likewise generate audible sound for a user, such as through a speaker, e.g., in a handset of device 950. Such sound may include sound from voice telephone calls, may include recorded sound (e.g., voice messages, music files, etc.) and may also include sound generated by applications operating on device 950.

The computing device 950 may be implemented in a number of different forms, as shown in the figure. For example, it may be implemented as a cellular telephone 980. It may also be implemented as part of a smart phone 982, personal digital assistant, or other similar mobile device.

Various implementations of the systems and techniques described here can be realized in digital electronic circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" and "computer-readable medium" refer to any computer program product, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

To provide for interaction with a user, the systems and techniques described here can be implemented on a computer having a display device (e.g., a CRT (cathode ray tube) or LCD (liquid crystal display) monitor) for displaying information to the user and a keyboard and a pointing device (e.g., a mouse or a trackball) by which the user can provide input to the computer. Other kinds of devices can be used to provide for interaction with a user as well; for example, feedback provided to the user can be any form of sensory feedback (e.g., visual feedback, auditory feedback, or tactile feedback); and input from the user can be received in any form, including acoustic, speech, or tactile input.

The systems and techniques described here can be implemented in a computing device that includes a backend component (e.g., as a data server), or that includes a middleware component (e.g., an application server), or that includes a front end component (e.g., a client computer having a graphical user interface or a Web browser through which a user can interact with an implementation of the systems and techniques described here), or any combination of such backend, middleware, or frontend components. The components of the system can be interconnected by any form or medium of digital data communication (e.g., a communication network). Examples of communication networks include a wireless communication network (e.g., 4G, 5G, etc.), a local area network ("LAN"), a wireless local area network ("WLAN"), a wide area network ("WAN"), and the Internet.

The computing device can include clients and servers. A client and server are generally remote from each other and typically interact through a communication network. The relationship of client and server arises by virtue of computer programs running on the respective computers and having a client-server relationship to each other.

A number of embodiments have been described. Nevertheless, it will be understood that various modifications may be made without departing from the spirit and scope of the invention.

In addition, the logic flows depicted in the figures do not require the particular order shown, or sequential order, to achieve desirable results. In addition, other steps may be provided, or steps may be eliminated, from the described flows, and other components may be added to, or removed from, the described systems. Accordingly, other embodiments are within the scope of the following claims.

## Claims

1. A computer system (100) for analyzing the technical state of an industrial system (200), the computer system (100) comprising:
an interface module (110) configured to:
access a plurality of signals (SS1 to SSm) describing the technical state of the industrial system (200) at respective time points wherein the signals correspond to or are derived from raw sensor data generated by sensors (S1 to Sn) of the industrial system (200);
receive an indicator (I1) for at least one signal of interest (Sol) to be used for diagnosis of the current technical state; and
provide one or more further signals (AS) associated with the at least one signal of interest (Sol) to a diagnostic system analysis user (10) as a recommendation (R1) for an enhanced set of diagnostic parameters reflecting the current technical state of the industrial system (200); and
a data analyzer module (120) configured to retrieve the associated signals (AS) from the plurality of signals (SS1 to SSm), wherein the associated signals are determined by one or more of the following criteria:
use of the associated signals (AS) in combination with the at least one signal of interest (Sol) in diagnostic activities regarding an abnormal technical state in the past,
existence of technical dependencies between the at least one signal of interest (Sol) and the associated signals (AS), and
result of a problem resolution activity in the past as a result of diagnostic activities based on the associated signals (AS) in combination with the at least one signal of interest (Sol) regarding an abnormal technical state in the past.

2. The computer system of claim 1, wherein the interface module (110) is further configured to receive a time interval indicator (I2), the computer system further comprising:
a time filter module (140) configured to filter the associated signals in accordance with the time interval indicator (12).

3. The computer system of any of the previous claims, further comprising:
a ranking scheme (150) which defines different weights for the respective retrieval criteria;
wherein the data analyzer (120) is further configured to apply the ranking scheme to the associated signals (AS) so that the retrieved associated signals are ranked in accordance with the ranking scheme and the associated signals are presented to a diagnostic system analysis user (10) according to their ranking with the highest ranked associated signal first.

4. The computer system of any of the previous claims, wherein the data analyzer is further configured to:
retrieve a particular device type associated with the device of which the technical state is monitored by the at least one signal of interest (Sol); and
determine one or more behavior properties of the at least one signal of interest (Sol) which were used for previous diagnostic activities regarding the technical state of devices having the particular device type;
wherein the associated signals are determined based on the one or more determined behavior properties.

5. The computer system of any of the previous claims, wherein the at least one signal of interest (Sol) relates to the technical state of a particular device of the industrial system (200) and the data analyzer 120 is further configured to retrieve associated signals which relate to the same particular device, or to retrieve associated signals which relate to the technical state of a further device of the industrial system (200), the further device having the same device type as the particular device.

6. A computer-implemented method (1000) for analyzing the technical state of an industrial system (200), comprising:
accessing (1100) a plurality of signals (SS1 to SSm) describing the technical state of the industrial system (200) at respective time points wherein the signals correspond to or are derived from raw sensor data generated by sensors (S1 to Sn) of the industrial system (200);
receiving (1200) an indicator (I1) for at least one signal of interest (Sol) to be used for diagnosis of the current technical state;
retrieving (1300) one or more further signals (AS) associated with the at least one signal of interest wherein the associated signals are determined by one or more of the following criteria:
use of the associated signals in combination with the at least one signal of interest in diagnostic activities regarding an abnormal technical state in the past,
existence of technical dependencies between the at least one signal of interest and the associated signals, and
result of a problem resolution activity in the past as a result of diagnostic activities based on the associated signals in combination with the at least one signal of interest regarding an abnormal technical state in the past; and
providing (1500) the associated signals (AS) to a diagnostic system analysis user (10) as a recommendation (R1) with an enhanced set of diagnostic parameters reflecting the current technical state.

7. The method of claim 6, wherein the use of the associated signals in the past is based on one or more of the following criteria:
the associated signals were retrieved within a predefined time interval around the retrieval time point of the at least one signal of interest in previous diagnostic activities with a probability above a predefined threshold,
the associated signals were configured in a respective diagnosis user interface in combination with the at least one signal of interest by a minimum number of diagnostic system analysis users,
the associated signals were configured in a respective diagnosis user interface in combination with the at least one signal of interest by an expert user, and
the combination of the associated signals with the at least one signal of interest was marked with one or more indicators for the usefulness of diagnostic activities in the past by one or more diagnostic system analysis users.

8. The method of claim 6 or 7, wherein the existence of the technical dependencies is based on one or more of the following criteria:
the associated signals have a connection with the at least one signal of interest in a process and instrumentation diagram,
in the industrial system (200) the sensors related to the associated signals (AS) are in physical proximity to the sensor related to the at least one signal of interest (Sol),
the occurrences of the associated signals (AS) show a correlation with the occurrences of the at least one signal of interest for one or more signal sequences in the past, and
the associated signals (AS) have one or more causal relationship with the at least one signal of interest (Sol) or amongst each other.

9. The method of any of the claims 6 to 8, wherein the at least one signal of interest relates to the technical state of a particular device of the industrial system and the associated signals relate to the same particular device.

10. The method of any of the claims 6 to 8, wherein the at least one signal of interest relates to the technical state of a particular device of the industrial system and the associated signals relate to the technical state of a further device of the industrial system, the further device having the same device type as the particular device.

11. The method of any of the claims 6 to 10, further comprising:
upon receiving (1200) the indicator for the at least one signal of interest, retrieving (1210) a particular device type associated with the device of which the technical state is monitored by the at least one signal of interest (Sol); and
determining (1220) one or more behavior properties of the at least one signal of interest which were used for previous diagnostic activities regarding the technical state of devices having the particular device type;
wherein the associated signals are determined based on the one or more determined behavior properties.

12. The method of any of the claims 6 to 11, wherein receiving an indicator for a at least one signal of interest includes receiving a time interval indicator (I2), the method further comprising:
prior to providing (1500) the associated signals to the diagnostic system analysis user, filtering (1400) the associated signals (AS) in accordance with the time interval indicator (I2).

13. The method of claim 12, wherein providing the associated signals to the diagnostic system analysis user further comprises:
highlighting (1600) at least a subset of the associated signals if the subset relates to an alarm which occurred during the time interval of interest.

14. The method of any of the claims 6 to 13, wherein the retrieved associated signals are ranked in accordance with a ranking scheme (150) which defines different weights for the respective retrieval criteria and providing (1500) the associated signals to a diagnostic system analysis user further comprises:
presenting the associated signals according to their ranking with the highest ranked associated signal first.

15. A computer program product comprising instructions that when loaded into a memory of a computing device and executed by at least one processor of the computing device cause the computing device to execute the steps of the computer-implemented method according to any one of the claims 6 to 14.
